# EUROPEAN PATENT SPECIFICATION

(11) **EP 2 499 682 B1**
(45) Date of publication and mention of the grant of the patent: **30.03.2016**
(21) Application number: 10787592.4
(22) Date of filing: 12.11.2010
(51) Int. Cl.: H01L 41/04, B05B 17/06

(54) **RESONANT CIRCUIT FOR DRIVING A PIEZOELECTRIC ELEMENT**
RESONANTE TREIBERSCHALTUNG FÜR EIN PIEZOELEKTRISCHES ELEMENT
CIRCUIT RÉSONNANT DE COMMANDE D'UN ÉLÉMENT PIÉZO-ÉLECTRIQUE

(30) Priority: 13.11.2009 US 260967 P
(43) Date of publication of application: 19.09.2012
(73) Proprietor: S.C. Johnson & Son, Inc., Racine, WI 53403 (US)
(72) Inventor: LUC, Tai, P., Oak Creek, Wisconsin 53154 (US); SIPINSKI, Gene, Elgin, Illinois 60123 (US); NORWOOD, Richard, L., Racine, Wisconsin 53403 (US)
(74) Representative: Ruschke, Hans Edvard
(86) International application number: PCT/US2010/002955
(87) International publication number: WO 2011/059494

(56) References cited:
- WO-A1-97/31721
- US-A- 4 628 275
- US-A1- 2007 046 143

## Description

### BACKGROUND

### 1. Technical Field

The present application relates to resonant circuits, and, more particularly, to systems and methods of controlling a resonant circuit. 2. Description of the Background

Resonant devices have been used to dispense volatilizable substances, such as fragrances. These resonant devices have typically been in the form of piezoelectric transducers, which exhibit resonant characteristics at one or more ultrasonic mechanical vibration frequencies. In most cases, the principal resonant frequency (i.e., the frequency at which the highest Q factor is achieved) is only approximately known, because of manufacturing tolerances, material differences, and the like. Because it is desirable to operate such a piezoelectric transducer at the principal resonant frequency for the sake of efficiency, past ultrasonic transducer control systems have utilized a methodology that sweeps the driving waveform for the piezoelectric transducer over a range that causes the transducer to vibrate over a range of mechanical frequencies including the principal resonant frequency.

Still other ultrasonic transducer control systems utilize an electrical impedance in the form of an inductor that is coupled in series or in parallel with the piezoelectric transducer. The inductor and the equivalent electrical impedance of the transducer form a tank circuit that naturally oscillates at a frequency that causes the piezoelectric transducer to vibrate at the principal resonant frequency thereof. While this approach results in a circuit that is highly efficient, prior circuit designs for accomplishing this operation have been complex.

WO 97/31721 shows an ultrasonic nebuliser in which the piezoelectric transducer is connected in series with an inductor and is driven from the midpoint of respectively two pairs of FETs connected across a power supply. The FETs are driven at an appropriate resonant frequency for the tank circuit consisting of the inductor and piezoelectric transducer. Resonance is detected by measuring the current flowing in the power supply by measuring voltage across a resistor in series with the entire output circuitry.

US 4,628,275 shows an amplifier for driving highly-capacitive loads, for example, piezoelectric actuators using pulse width modulation. Its output stage has a bridge of four FET transistors with the capacitive load in series with a further capacitor, a resistor R1 and an inductor L1. These components form a tank circuit. A driver circuit including a pair of comparators U1, U2 connected to the respective inputs of a flip-flop which, in turn, connects to the gates of the FET's such that in one state of the flip-flop outputs of the FET's cause full power supply potential to be applied to the tank circuit in an alternating polarity. The comparators couple to the resistor R1 in the tank circuit to detect whether the current in the tank circuit has reached respective thresholds defined by the input signal.

US 2007/0046143 shows a drive circuit for an ultrasonic piezoelectric actuator. In one arrangement a signal is fed back from a resistor in series with one of the pairs of output FETs to a logic circuit comprising gates and inverters where it produces a signal to drive on FET bridge.

The invention is as defined in claim 1 below. Optional features are set out in the dependent claims.

Other aspects and advantages will become apparent upon consideration of the following detailed description.

### BRIEF DESCRIPTION OF THE DRAWINGS

FIG. 1 is a top isometric view of a light and volatile substance emitting device;
FIG. 1A is a cross-sectional view taken generally along lines 1A-1A of FIG. 1 illustrating the cover of the device;
FIG. 2 is an exploded isometric view of the device of FIG. 1 with a housing cover removed therefrom;
FIG. 3 is a bottom elevational view illustrating the device of FIG. 1;
FIG. 4 is a block diagram of an application specific integrated circuit (ASIC) coupled to a resonant circuit and an LED wherein such circuits may be used in the device of FIG. 1;
FIG. 4A is a block diagram of the circuits of FIG. 4 in conjunction with an optional BOOST SWITCH;
FIGS. 5A-5K, when joined along similarly-lettered lines, represent various program portions stored in or otherwise made available for execution by the ASIC of FIGS. 4 or 4A;
FIGS. 6A and 6B are combined graphs and waveform diagrams that illustrate operation of the device of FIG. 1 in a first operating mode according to first and third portions of the programming as illustrated in FIG. 5A and FIGS. 5C-5E, respectively.
FIGS. 7A and 7B are combined graphs and waveform diagrams that illustrate operation of the device of FIG. 1 in a second operating mode according to a fifth portion of the programming as illustrated in FIGS. 5H and 5I;
FIG. 8 is a schematic diagram functionally illustrating a random number generator implemented by the ASICS of FIGS. 4 and 4A;
FIG. 9 is a waveform diagram illustrating another portion of the operation of the device of FIG. 1;
FIGS. 10 and 11 are tables illustrating timing of light and volatile substance emission by the device of FIG. 1; and
FIG. 12 illustrates an interrupt program that is executed by the ASIC of FIGS. 4 or 4A.

Throughout the figures, like or corresponding reference numerals have been used for like or corresponding parts.

### DETAILED DESCRIPTION OF THE PREFERRED EMBODIMENTS

A circuit for driving a piezoelectric actuator at a resonant frequency in which an impedance, such as an inductor, is coupled to the actuator is disclosed herein. The circuit can operate in a plurality of modes. The modes comprise a first mode wherein a first volatile substance and/or light may be emitted, and a second mode wherein a second volatile substance and/or light may be emitted. The second volatile substance may be different than or the same as the first volatile substance.

While a preferred embodiment of a device 30 emits an active material, preferably a fragrance and/or an insecticide, and much of the discussion below will be with regard thereto, it is also contemplated that the device 30 may alternatively dispense other substances, such as a disinfectant, a sanitizer, an insect repellant other than an insecticide, an insect attractant, air purifiers, aromatherapy, scents, antiseptics, odor eliminators, air-fresheners, deodorizers, and other active ingredients that are usefully dispersed into the air.

The device 30 preferably includes an electrically-powered light source, an active material dispenser, a power source, control circuitry, and a support structure. In the first mode, some or all of these components work together to provide a fragrant aroma and/or the appearance of a flickering flame wherein the flickering effect is provided by the electrically-powered light source. In the second mode, some or all of these components work together to provide an insecticide and/or the appearance of a flickering flame. The capability to operate in either mode (and variants of these operational modes, as described hereinafter) is programmed into the control circuitry so that a designer, builder, or even user of the device can select which mode (and one or more variants thereof) can be implemented.

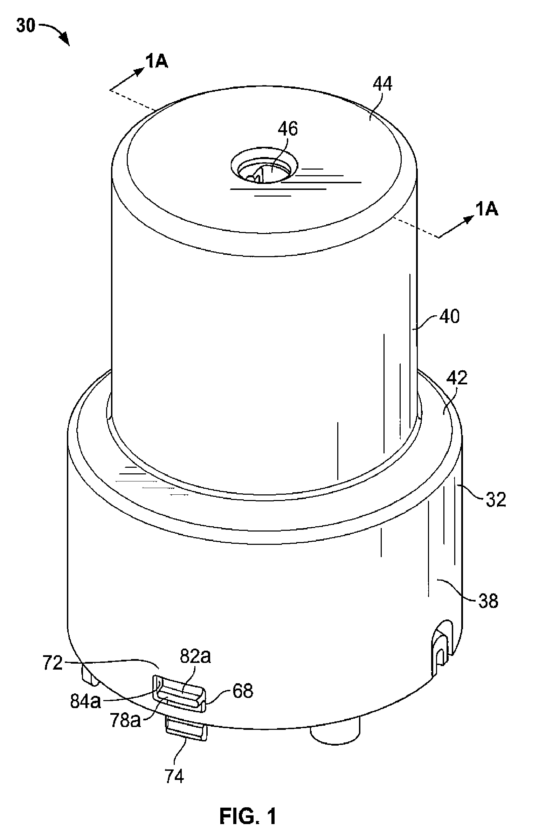

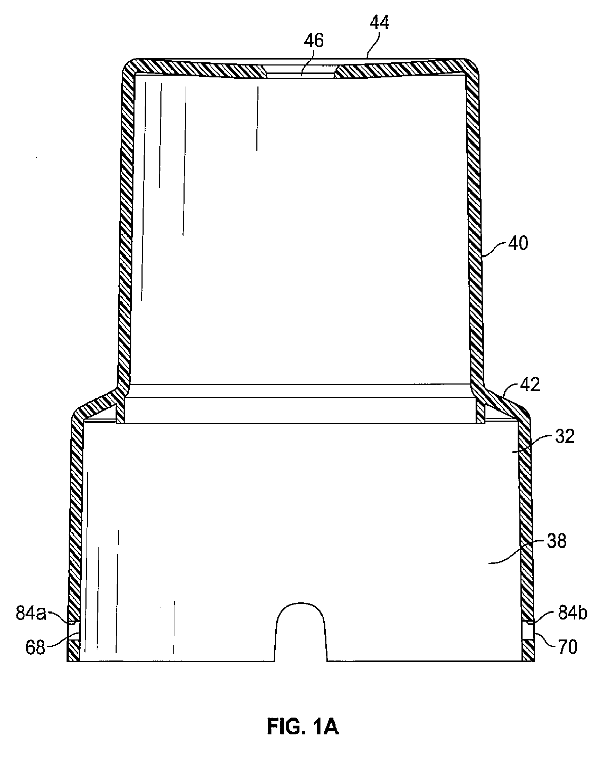

In one embodiment depicted in FIGS. 1, 1A, 2, and 3, the device 30 generally includes a cover 32 and a base portion 34. The cover 32 preferably includes a lower cylindrical wall 38 having a first diameter and an upper cylindrical wall 40 having a second diameter that is smaller than the first diameter. An angled wall 42 joins the lower cylindrical wall 38 to the upper cylindrical wall 40. The cover 32 further includes a circular top wall 44 adjacent the upper cylindrical wall 40 and has a circular aperture 46 disposed in a central portion thereof. The circular aperture 46 provides an outlet for the volatile substance that is emitted from the device 30.

The base portion 34 includes a housing 52 for enclosing control circuitry (described in detail below) for the device 30. A column 54 extends upwardly from the housing 52 and is preferably integral with the housing 52. Further, an arm portion 56 extends perpendicularly from the column 54 and is integral with the column 54. The arm portion 56 includes a volatile substance dispenser in the form of an atomizer assembly 58 that extends through a center portion 60 thereof.

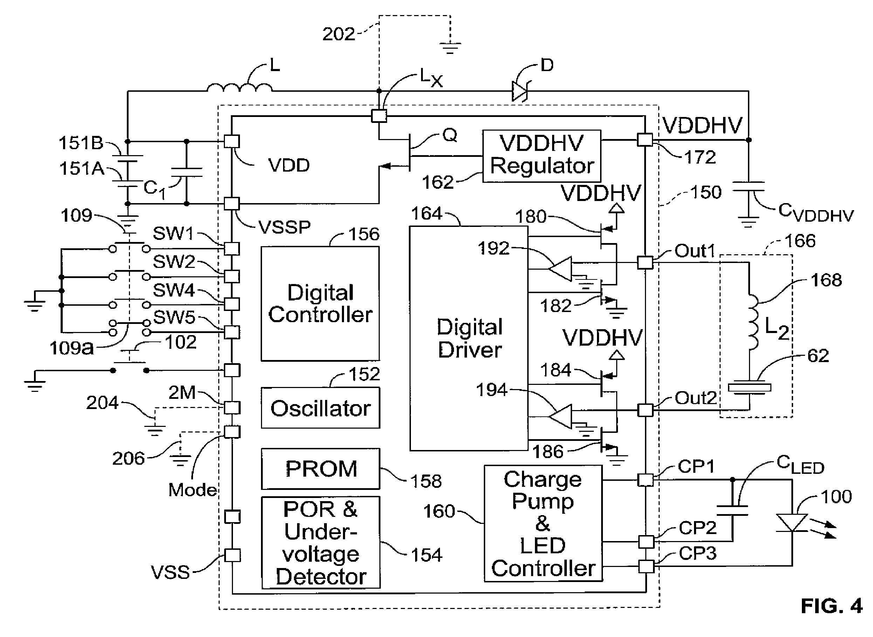

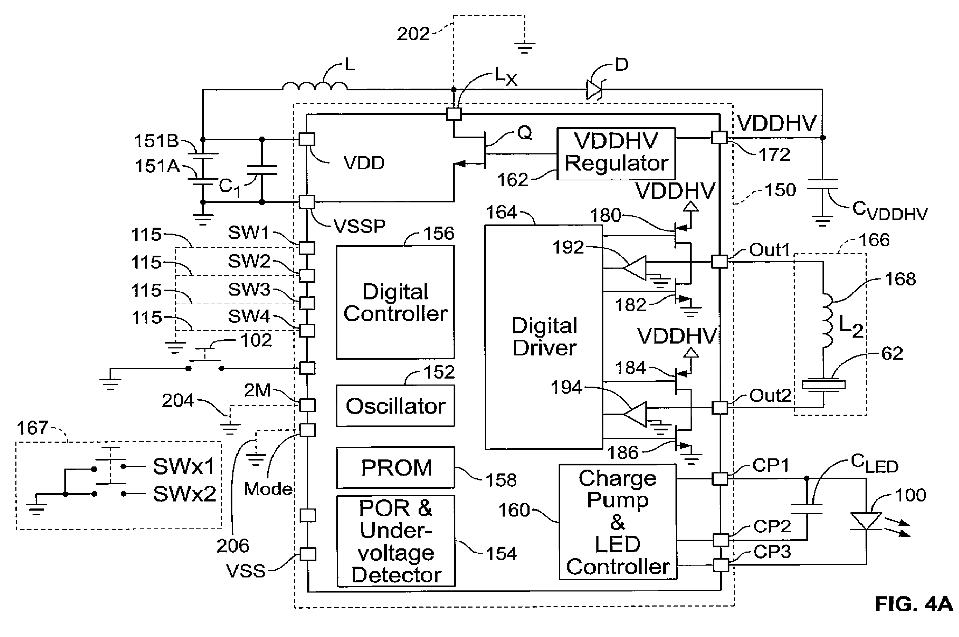

The atomizer assembly described in commonly owned U.S. Patent Publication No. 2006/0120080, filed November 2, 2005 may be utilized as the atomizer assembly 58. In general, the atomizer assembly 58 comprises a piezoelectric transducer element 62 (shown in FIGS. 4 and 4A) that is coupled to a perforated orifice plate 64, which in turn is in surface tension contact with a liquid source. The control circuitry applies an alternating voltage to a piezoelectric transducer element 62 to cause the piezoelectric transducer element 62 to expand and contract. The expansion and contraction of the piezoelectric transducer element 62 causes the orifice plate 64 to vibrate up and down, whereupon liquid is driven through the perforations in the orifice plate 64 and is then emitted upwardly in the form of aerosolized particles.

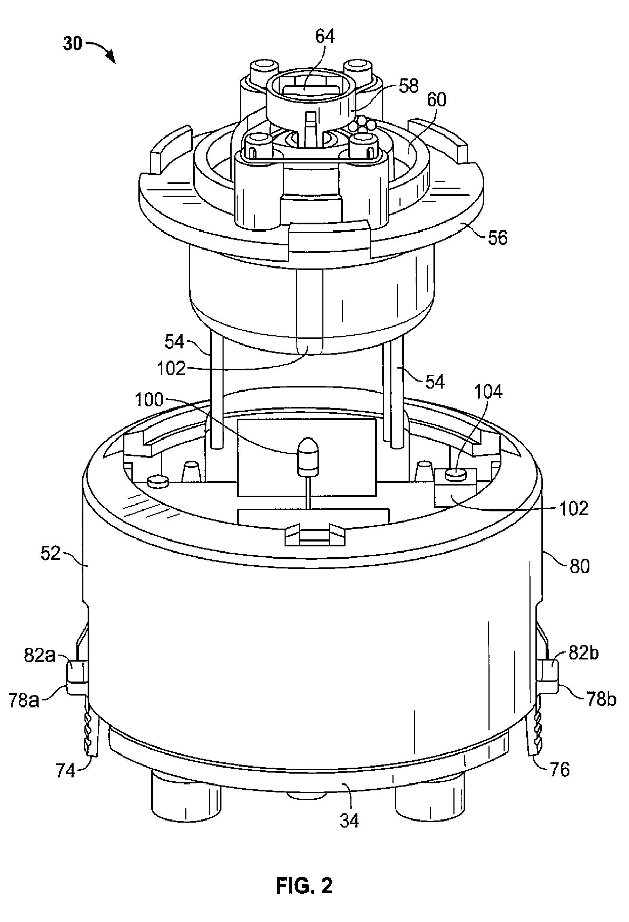

The cover 32 is positioned over the housing 52 during use of the device 30. Specifically, the cover 32 includes a first aperture 68 and a second aperture 70 (FIG. 1A) disposed diametrically opposite one another in a periphery 72 of the lower cylindrical wall 38. The base portion 34 includes first and second spring clips 74, 76 as seen in FIG. 2 extending from opposite sides of the housing 52. Each of the spring clips 74, 76 includes a protrusion 78a, 78b, respectively, extending outwardly therefrom. In use, the cover 32 is placed over the base portion 34 such that the upper cylindrical wall 40 surrounds the column 54, the arm portion 56, and the atomizer assembly 58, and the lower cylindrical wall 38 abuts an outer wall 80 of the housing 52. As the cover 32 is placed over the base portion 34, the spring clips 74, 76 are pressed inwardly by a user. Once the first and second apertures 68, 70 are aligned with the protrusions 78a, 78b extending from the spring clips 74, 76, the user may release the spring clips 74, 76. As the spring clips 74, 76 are released, the protrusions 78a, 78b move outwardly into the apertures 68. Walls 82a, 82b (FIG. 2) defining each protrusion 78a, 78b, respectively, interfere with walls 84a, 84b (FIG. 1A) defining the respective aperture 68, 70 to prevent removal of the cover 32 from the base portion 34.

The control circuitry is disposed on a printed circuit board (PCB) (not shown) within the housing 52. A light emitting diode (LED) 100 is operatively connected to the PCB and extends upwardly therefrom. The PCB preferably includes an optional tactile switch 102 having a depressible button 104 extending upwardly therefrom. In one embodiment, depression of the depressible button 104 turns either a combination of the atomizer assembly 58 and the LED 100 on or off or turns the LED 100 alone on or off depending on which mode variant of operation has been established for the device 30. The operation of the atomizer assembly 58 and the LED 100 will be discussed in greater detail below.

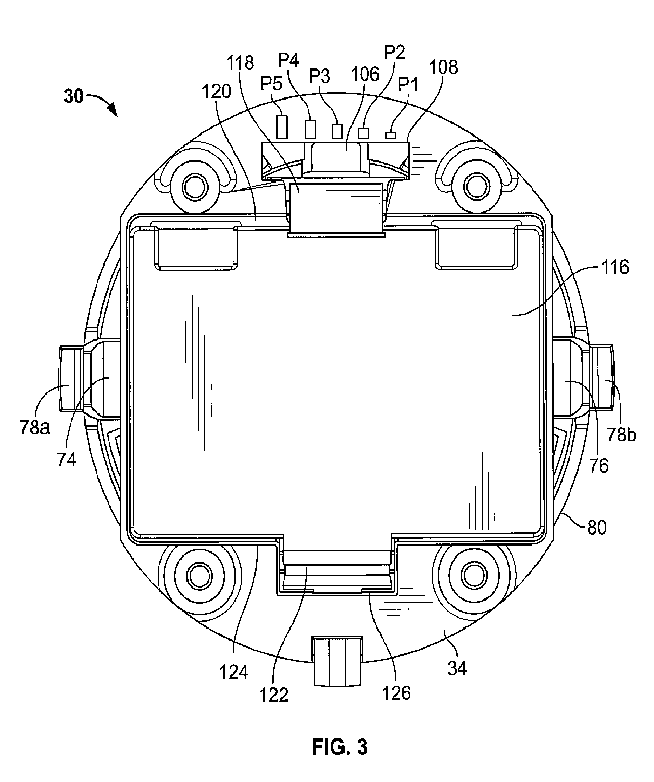

As seen in FIG. 3, an emission duty-cycle selector button 106 extends through a rectangular aperture 108 in a bottom end of the base portion 34 in one embodiment of the device 30. The emission duty-cycle selector button 106 is operatively coupled to a slide switch 109 carried by the PCB (shown in FIG. 4) to allow the user to select an emission duty-cycle for the atomizer assembly 58. In one embodiment, the actuator button 106 is movable to one of five selectable positions P1, P2, P3, P4, and P5 (FIG.3), that a user may select to vary the emission duty-cycle of the atomizer assembly 58. Specifically when the button 106 is moved to position P1, a wiper 109a of the switch 109 is positioned such that none of a plurality of input pins SW1, SW2, SW4, and SW5 of a programmable device (discussed in greater detail below) is coupled to ground. When the button 106 is moved to any of the positions P2-P5, an associated one of the input pins SW1, SW2, SW4, or SW5, respectively, is connected to ground. In another embodiment shown in FIG. 4A, the slide switch 109 is omitted and the builder or implementer of the device 30 predetermines the emission duty-cycle of the atomizer assembly 58 by connecting one or more of SW1, SW2, SW4, and SW5 to ground as shown by dashed lines 115.

The base portion 34 of the device 30 includes a battery door 116 that has a hinge 118 at a first end 120 thereof and a latching mechanism 122 at a second end 124 thereof. The latching mechanism 122 interacts with a locking recess 126 in the base portion 34 to hold the battery door 116 in a closed position. The latching mechanism 122 may be flexed to release the latching mechanism 122 from the locking recess 126, such that the battery door 116 may pivot about the hinge 118 to open the battery door 116 and allow access to a battery compartment (not shown). Any conventional dry-cell battery or batteries, such as A, AA, AAA, C, and D cells, button cells, watch batteries, and solar cells, but preferably, AA or AAA cell batteries, may be used with the device 30. Although two batteries are preferred, any number of batteries that would suitably fit within the device 30 and provide adequate power level and service life may be utilized. Optionally, the device 30 may be powered by alternating household current, which may be rectified, converted to high-frequency alternating current power, reduced in voltage, etc., and applied to the atomizer assembly 58 and/or the LED 100. While not shown herein, it is contemplated that the housing 52 may be adapted to prevent moisture from damaging the contents of the housing 52.

FIG. 4 illustrates the programmable device noted above, which is illustrated as being an application specific integrated circuit (ASIC) 150 that operates in conjunction with further electrical components to control the energization of the atomizer assembly 58 and the LED 100 described above. The ASIC 150 receives power from series connected batteries 151A, 151B coupled to terminals VDD and VSSP of the ASIC 150. A capacitor C1 is coupled across the terminals VDD and VSSP for filtering purposes. The ASIC 150 includes an internal debouncer (not shown in FIG. 4) that debounces the signal(s) developed by switches including the switch 102 when the switch 102 is incorporated in the circuit.

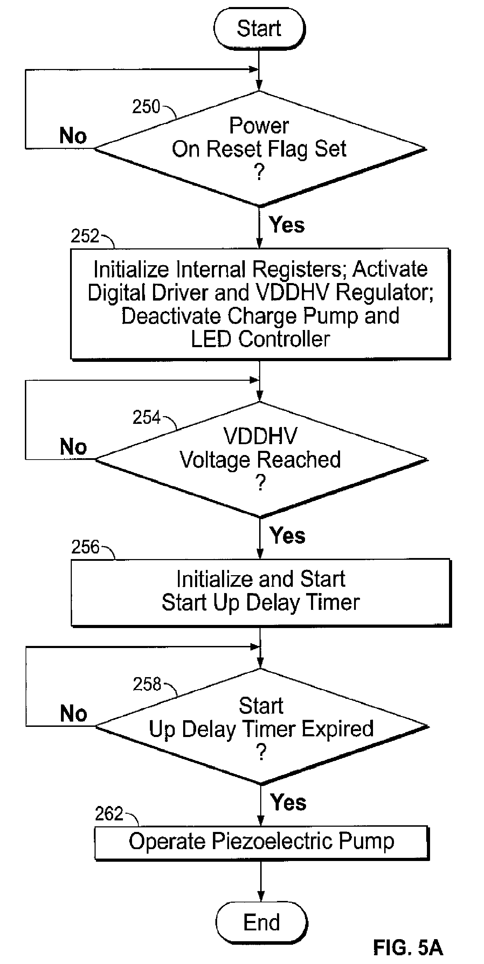

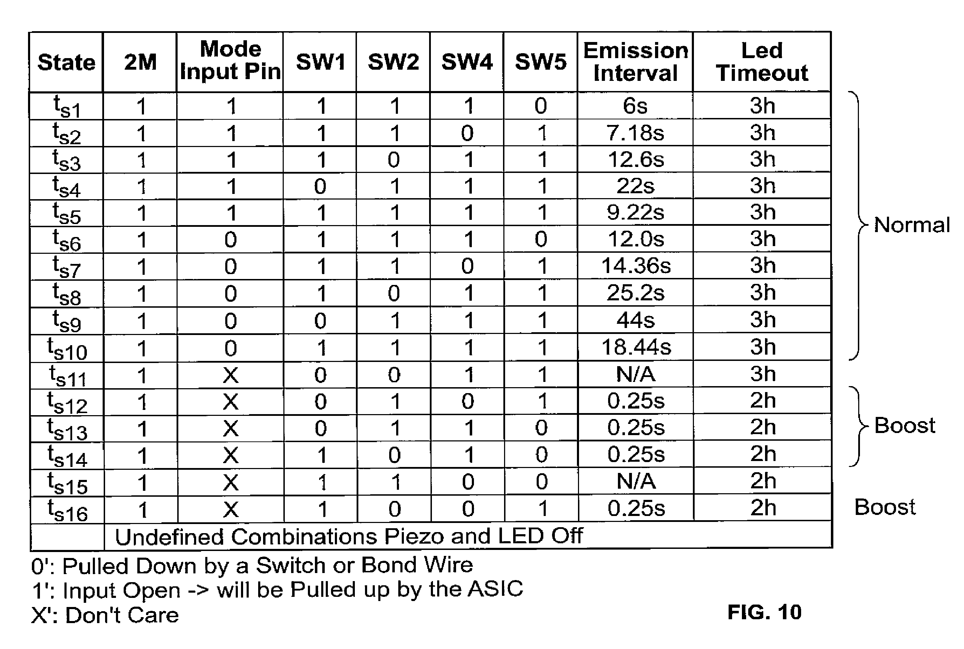

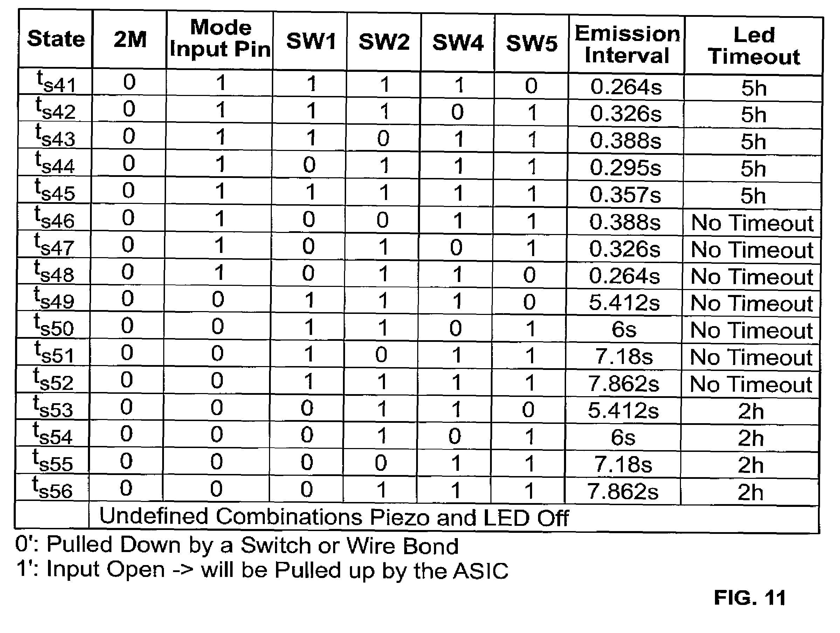

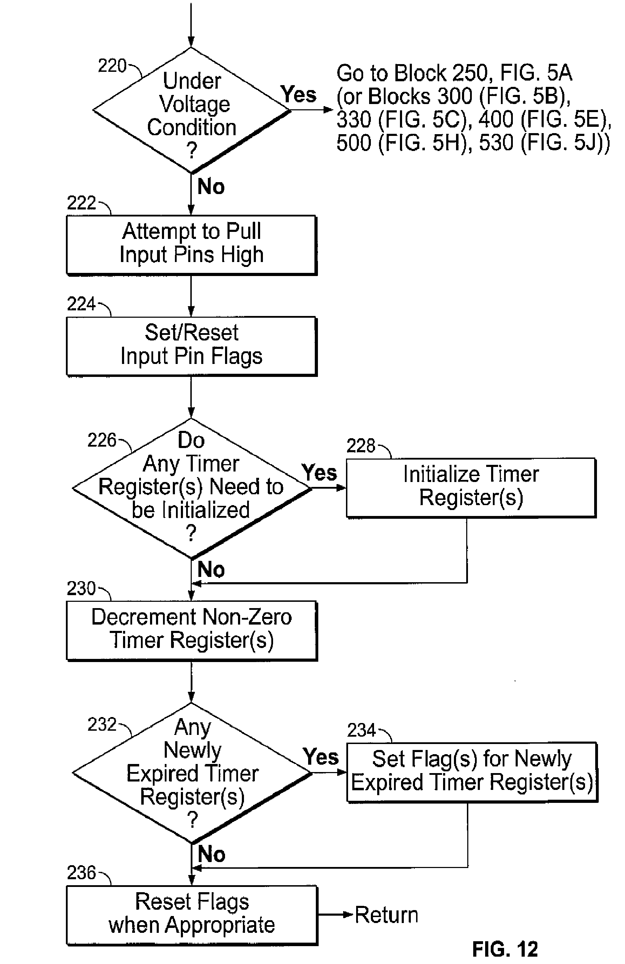

The ASIC 150 further includes an oscillator 152 that serves as an internal clock for the ASIC 150, and a power-on-reset and undervoltage detector 154. The power-on-reset portion of the undervoltage detector 154 sets or resets register(s) and/or flag(s) of the ASIC 150, as appropriate, and develops a power on reset signal upon energization of the ASIC 150. The undervoltage detector 154 interrupts the operation of the ASIC 150 when the battery voltage drops below a predetermined level as discussed hereinafter with respect to FIGS. 5A-5L and 12. The ASIC 150 is energized when the user connects the device 30 to a voltage source to power the device 30. The ASIC 150 is programmed to execute one or more program portions stored for use by the ASIC 150 in internal and/or external memory according to the flowcharts of FIGS 5A-5K and further in accordance with the tables of FIGS. 10 and 11 to implement one of two modes of operation, wherein each mode includes variants thereof, and wherein either mode of operation (or mode variant) may be selected by configuring the device 30 as noted hereinafter. The ASIC 150 may further include a digital controller 156, a programmable read-only memory 158, and a charge pump and LED controller 160 that generates drive waveforms for the LED 100. In addition, the ASIC 150 includes a voltage regulator 162 and a digital driver 164 that drives a piezoelectric pump 166. The piezoelectric pump 166 includes an inductor 168 that is coupled in series with the piezoelectric transducer element 62. The piezoelectric pump 166 is coupled to the digital driver 164 through four switches that are operatively connected in a full bridge configuration. As shown in this embodiment, the switches are n-channel and p-channel FET's 180, 182, 184, 186. Other types of transistors and/or topologies (e.g., a half-bridge topology) may be utilized in different embodiments. An inductor L and a diode D operate in conjunction with an internal transistor Q and the voltage regulator 162 to develop a regulated voltage VDDHV at a terminal or pin 172. The regulated voltage VDDHV provides a high voltage level for the FET's 180, 182, 184, 186. Specifically, drain electrodes of a first p-channel FET 180 and a first n-channel FET 182 are coupled together at a first drain junction that is, in turn, coupled to a pin OUT1 of the ASIC 150. Drain electrodes of a second p-channel FET 184 and a second n-channel FET 186 are coupled together at a second drain junction that is, in turn, coupled to a pin OUT2 of the ASIC 150. Each source electrode of the first and second p-channel FET's 180, 184 is coupled to the regulated voltage VDDHV and each source electrode of the first and second n-channel FET's 182, 186 is coupled to ground VSSP.

A first input of a first voltage comparator 192 is coupled to the pin OUT1 and a second input of the first voltage comparator 192 is coupled to ground. Similarly, a first input of a second voltage comparator 194 is coupled to the pin OUT2 and a second input of the second voltage comparator 194 is coupled to ground. Each output of the first and second voltage comparators 192, 194 is coupled to the digital driver 164. Each gate electrode of the FET's 180, 182, 184, 186 is coupled to the digital driver 164, which sends control waveforms to the FET's 180, 182, 184, 186 to drive the piezoelectric pump 166 when the undervoltage detector 154 senses the appropriate regulated voltage VDDHV at the terminal 172 and the ASIC 150 is operable in the first operating mode. Similarly, the digital driver 164 sends control waveforms to the FET's 180, 182, 184, 186 when the ASIC 150 is operable in the second mode of operation and the undervoltage detector 154 senses the appropriate regulated voltage VDDHV at the terminal 172 and the user depresses the button 104 to close the switch 102. Specifically, the digital driver 164 transmits waveforms to switch the first p-channel FET 180 and the second n-channel FET 186 on while holding the second p-channel FET 184 and the first n-channel FET 182 in an off condition to cause current to flow through the piezoelectric pump 166. The voltage applied to the piezoelectric pump 166 is not in phase with the current flowing therethrough. Accordingly, at some point, the current flow through the piezoelectric pump 166 attempts to reverse direction, and when a zero-crossing of such current is detected by the second voltage comparator 194, the digital driver 164 causes the FET's 180, 186 to turn off. Thereafter, the digital driver 164 transmits waveforms to switch the FET's 182, 184 on while holding the FET's 180, 186 in an off condition to cause current to flow through the piezoelectric pump 166 in a second direction. Similarly, at some point, the current flow through the piezoelectric pump 166 again attempts to reverse direction, and when a zero-crossing of such current is detected by the first voltage comparator 192 the digital driver 164 causes the FET's 182, 184 to turn off and the FET's 180, 186 to turn on as described above. A period of time may be interposed between turn-off of one pair of FET's and turn-on of another pair of FET's during which all the FET's are briefly turned off to prevent a short circuit condition.

The current through the piezoelectric pump 166 alternates at a selected resonant frequency thereof depending upon the impedance of the resonant circuit comprising the inductor 168 and the piezoelectric transducer element 62. This oscillation occurs in a continuous or discontinuous fashion during each emission sequence, following which the digital driver 164 turns off the control waveforms to the FET's 180-186 to turn the piezoelectric pump 166 off and to terminate further emission of active material by the piezoelectric transducer element 62.

In the first mode, which is commanded by leaving a pin 2M unconnected to a voltage level, the device 30 is controlled to dispense a fragrance during spaced approximate 12ms spray periods (or spray periods of other fixed or variable durations) and user-selectable or predefined fixed or variable dwell periods are interposed between successive spray periods, as seen in FIG. 10 (the term "emission interval" used in FIGS. 10 and 11 refers to a complete cycle duration consisting of one spray period and one dwell period.). In one embodiment of the first mode, two terminals SWx1 and SWx2 of an optional boost switch 167 (FIG. 4A) may be connected to a selected or predetermined two of the four input pins SW1, SW2, SW4, and SW5. The switch 102 may optionally be omitted in embodiments that incorporate the boost switch 167. The boost switch 167 connects the selected or predetermined two input pins to ground when the boost switch 167 is closed to cause the device 30 to emit fragrance at selectable duty cycles different than (preferably, greater than) those described above, as will be explained below with respect to FIG. 10.

In the second mode, which is commanded by connecting a pin 2M to ground and which will be discussed in detail hereinafter with respect to FIG. 11, the device 30 is controlled to dispense an insecticide or other insect repellant during spaced approximate 12ms spray periods (or spray periods of other fixed or variable duration) and shorter predetermined dwell periods are interposed between spray periods as compared to operation in the first mode (these dwell periods can be user-selectable or may be predefined fixed or variable dwell periods).

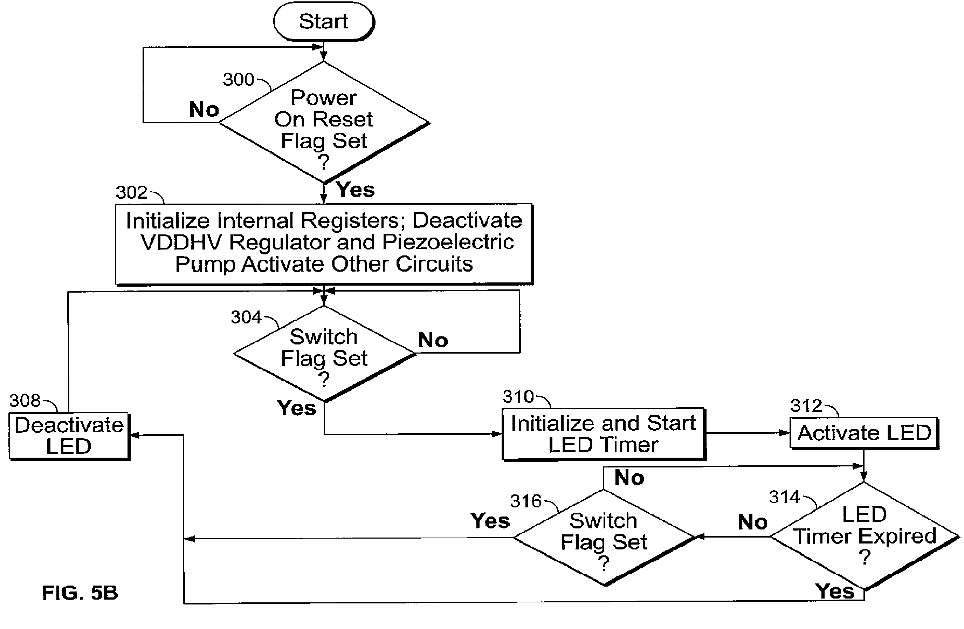

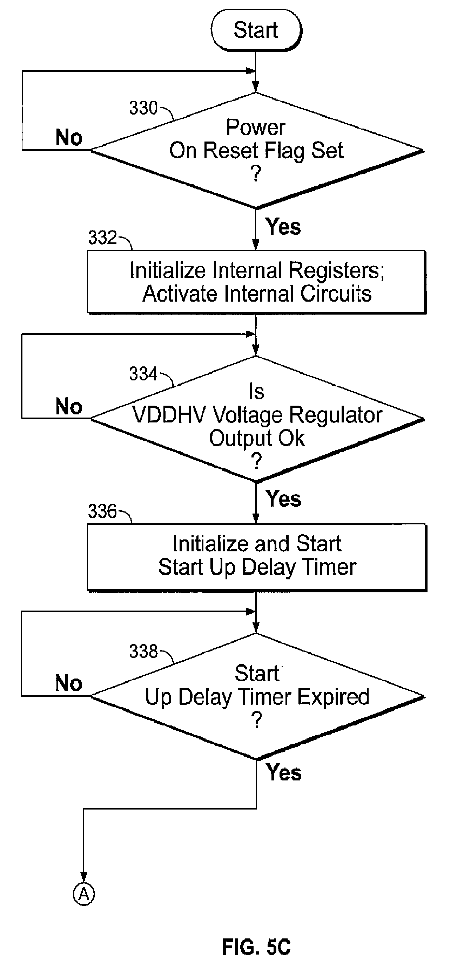

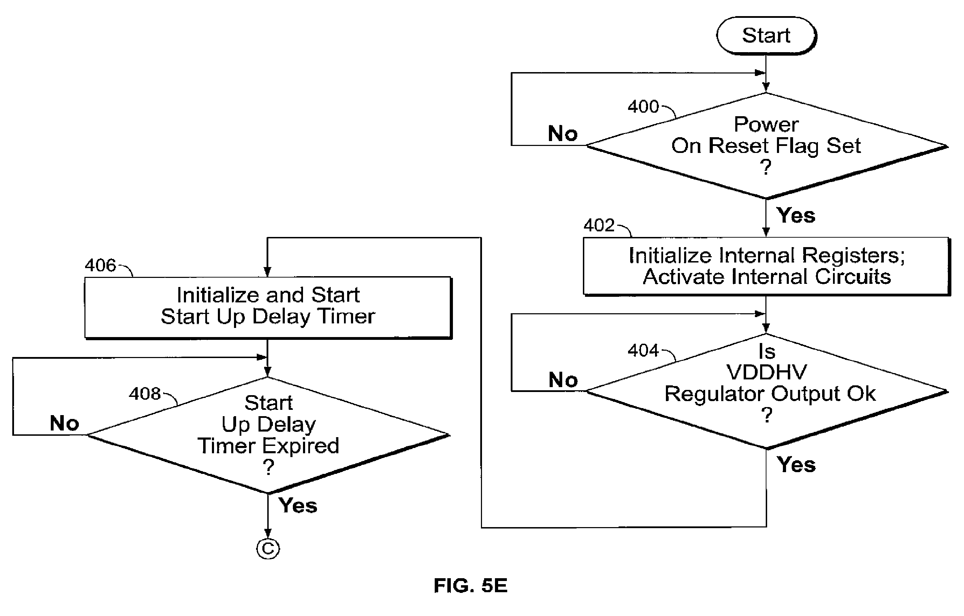

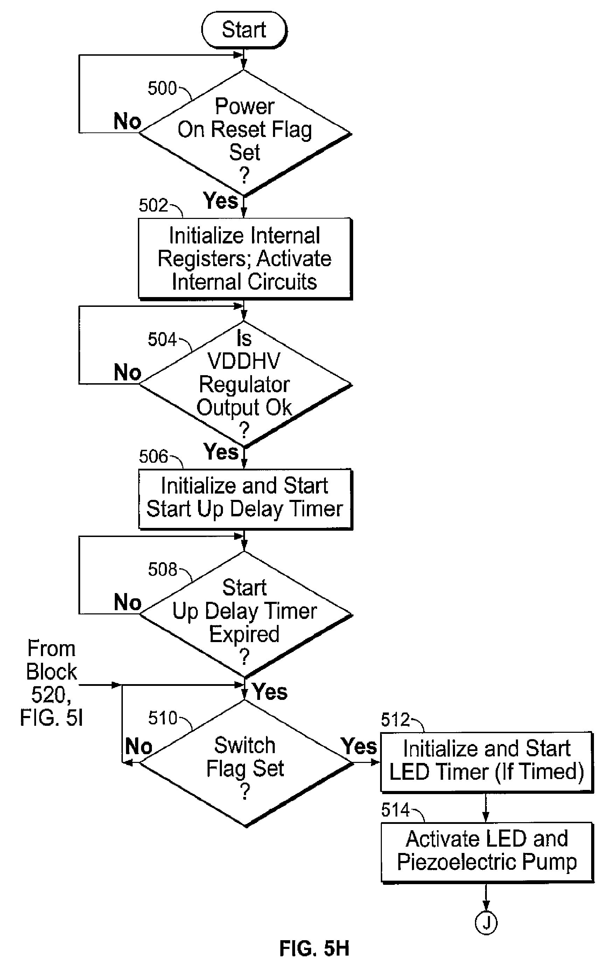

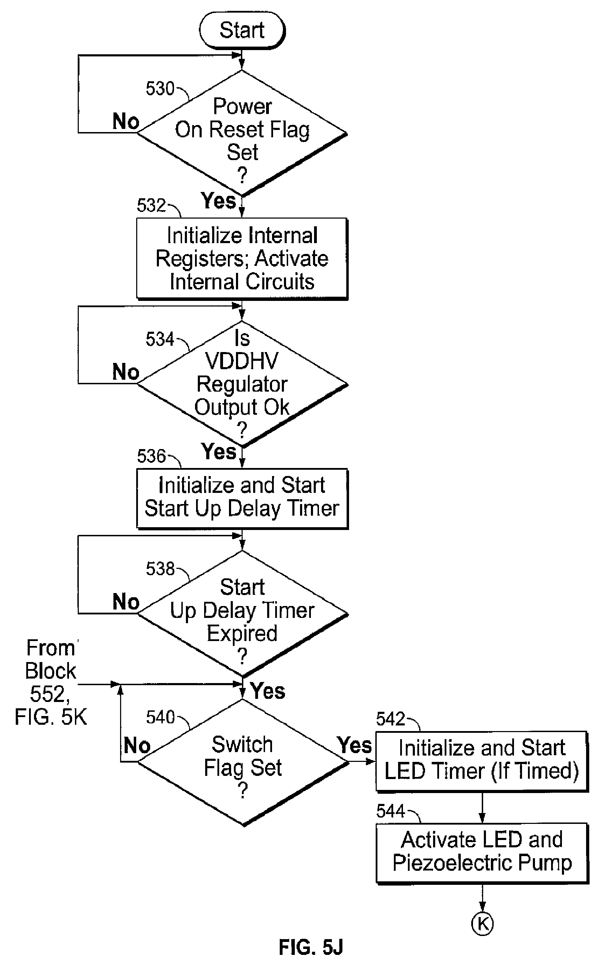

FIG. 12 illustrates the operation of an interrupt routine that is executed once every 250ms by the ASIC 150 during the operation of any of a number of portions of a main program as will be described below with respect to FIGS. 5A-5K. Operation of the interrupt routine begins at a block 220 that determines whether a voltage delivered across the VSSP and VDD inputs by the batteries 151A, 151B is higher than or equal to a predetermined voltage level. The block 222 makes this determination by checking the status of a VOLTAGE LEVEL flag maintained by the ASIC 150. If the VOLTAGE LEVEL flag is set (i.e., the voltage across the VSSP and VDD inputs is greater than or equal to the predetermined voltage level), control passes to a block 222 that attempts to pull all the input pins of the ASIC 150 to a high voltage level to read such input pins. If the block 220 determined that the VOLTAGE LEVEL flag is not set (i.e., the voltage across the VSSP and VDD inputs is lower than the predetermined voltage level), control passes to one of a number of blocks 250 (FIG. 5A), 300 (FIG. 5B), 330 (FIG. 5C), 400 (FIG. 5E), 500 (FIG. 5H), or 530 (FIG. 5J) depending upon the portions of the programming of the ASIC 150 that is active (i.e., being executed). Following the block 222, control passes to a block 224 that sets or resets, (according to the selected logic being used) flags representing states of the signals and waveforms appearing at the inputs of the ASIC 150 (e.g., whether high or low logic levels are present at certain inputs) as well as certain other flags as commanded by the active main program portion. In the illustrated routine, the block 224 causes the interrupt routine to set an LED flag on a rising edge of the switch 102 input waveform. A block 226 determines whether any timer register(s) need to be set to an initialized value predetermined for such timer register(s). The need to set the timer register(s) is commanded by the active main program portion. It is contemplated that all of the timer register(s) in any part of the program(s) disclosed herein may be initialized either to zero and incremented thereafter or the timer register(s) may be set to a non-zero value and decremented thereafter. For illustrative purposes, the timer register(s) herein are initialized to a non-zero value and expire when decremented to zero. If the block 226 determines that any timer register(s) need to be initialized, control passes to a block 228 that initializes such timer register(s) and control passes to a block 230 that decrements all non-zero timer register(s) by one. On the other hand, if the block 226 determines that there are no timer register(s) to be initialized, control passes directly to the block 230. Following the block 230, a block 232 determines whether there are any newly expired timer register(s) (i.e., timer register(s) that have just been decremented to zero by the block 230). If so, control passes to a block 234 that sets flag(s) for all newly expired timer register(s).

A block 236 resets flags at appropriate times following the blocks 232, 234, and control thereafter returns to the active main program portion. In this regard, it should be noted that all flags set or reset by the programming of FIG. 12 remain in the set or reset state for a time duration that insures proper operation of the main program portions described hereinafter.

FIG. 5A illustrates a first portion of programming that is executed by the ASIC 150 to emit a volatile substance, but not light, from the device 30 using the circuits shown in FIG. 4. Specifically, the program is intended for use when the LED 100, a capacitor C_{LED}, (FIGS 4 and 4A) and the boost switch 167 are omitted. Further, a pin CP3 is connected to ground and the charge pump and LED controller 160 are deenergized to save power. Operation begins at the block 250 that checks a POWER ON RESET flag to determine whether a power-on-reset waveform has transitioned from a logical 0 to a logical 1. If so, a block 252 initializes all internal registers in the ASIC 150 to predefined startup values and activates the digital driver 164 and the VDDHV regulator 162. The block 252 also deactivates the charge pump and LED controller 160. On the other hand, control remains with the block 250 if the POWER ON RESET flag has not transitioned to a logical 1. Following the block 252, a block 254 determines whether a VDDHV flag is set. The VDDHV flag indicates whether the voltage at the pin 172 has reached a predetermined voltage level. Control remains with the block 254 until the voltage at the pin 172 has reached the predetermined VDDHV voltage level. Next, control passes to a block 256 that initializes and starts a START UP DELAY timer. Control passes to a block 258 that determines whether the START UP DELAY timer has expired by checking whether a START UP DELAY flag is set. Control remains with the block 258 until the START UP DELAY flag is set and control passes to a block 262 that operates the piezoelectric pump 166 in a selected normal mode. The selected normal mode is determined by the user setting of the rate selector switch 109 or as predetermined by connecting one or more of the inputs SW1, SW2, SW4, and/or SW5 to ground. The operation is illustrated by states tₛ₁-tₛ₁₀ of FIG. 10 (ignoring the column "LED TIMEOUT" inasmuch as the LED 100 is omitted).

The main program continues operation in the above-described sequence until the block 220 (FIG. 12) determines that the VOLTAGE LEVEL flag has been reset (i.e., the voltage across the VSSP and VDD inputs by the batteries 151A, 151B is lower than the predetermined voltage level). Thus, the volatile substance is emitted until the substance is exhausted or until the voltage supplied by the batteries 151A, 151B drops below the predetermined voltage level.

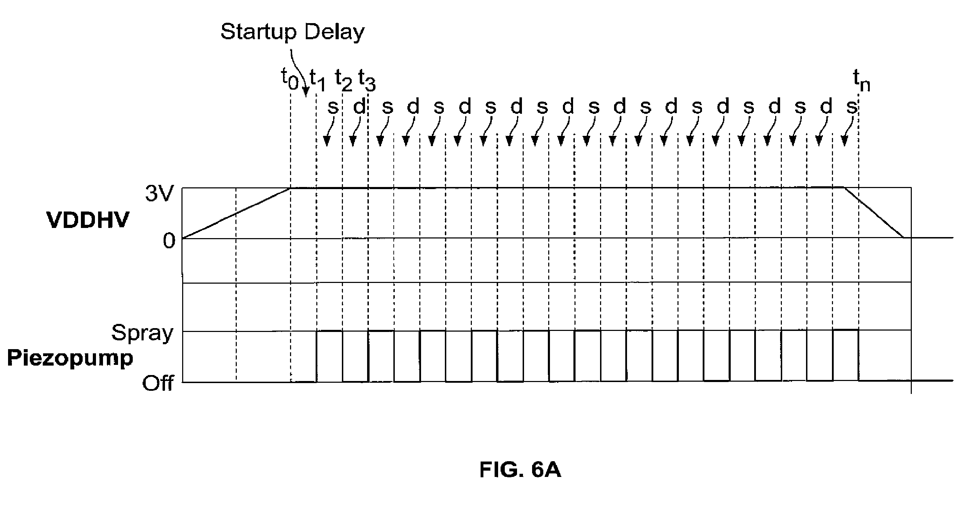

FIG. 6A illustrates the operation of the programming of FIG. 5A in the first mode to emit the first volatile substance. A waveform labeled "VDDHV" indicates the voltage at the pin 172. The voltage VDDHV reaches a predetermined voltage level (for example, 3v) at a time t₀. Following a predetermined startup delay between the time to and a time t₁, the piezoelectric pump 166 begins operation as shown by a graph labeled "Piezopump." A number of spray periods "s" having selectable dwell periods "d" interposed therebetween are depicted by the graph between a time t₁ and a time tₙ. The duration of each spray period and/or the duration of each dwell period is determined by connecting one or more of the inputs SW1, SW2, SW4, and/or SW5 to ground, for example, using the switch 109. The device 30 ceases emission of the volatile substance when an undervoltage condition occurs at the time tₙ.

FIG. 5B illustrates a second portion of programming that may be alternatively executed by the ASIC 150 and either of the circuits shown in FIGS. 4 or 4A. The programming of FIG. 5B is useful to operate the LED 100 alone without operating the piezoelectric pump 166, which may be omitted. In this embodiment, a pin Lₓ is connected to ground, such as seen at 202 in FIG. 4, and the digital driver 164 and associated internal circuits of the ASIC 150 are turned off to save power. Operation begins at a block 300, where control pauses until the power-on-reset signal has transitioned from a logical 0 to a logical 1. Once this occurs, control passes to a block 302 that initializes the internal registers and turns off the VDDHV regulator and the piezoelectric pump 166. The block 302 also turns on other circuits within the ASIC 150 such as the POWER ON RESET and undervoltage detector 154, the digital controller 156, the oscillator 152, and the memory 158. Following the block 302, a block 304 checks the SWITCH flag to determine whether such flag is set. The SWITCH flag is set when user has closed the switch 102 of FIGS. 4 or 4A. A user is considered to have closed the switch 102 when the user depresses the switch 102 for at least a debounce period. The debounce period is predetermined by the builder/designer of the device 30. If it is determined that the SWITCH flag is set, control passes to a block 310 that initializes and starts an LED timer and a block 312 turns on the LED 100. Next, control passes to a block 314 that checks an LED TIMER flag to determine whether the LED timer has expired. If so, control passes to a block 308 that deactivates the LED 100. Otherwise, control passes to a block 316 that again checks the SWITCH flag. If the block 316 determines that the SWITCH flag is not set, control returns to the block 314. On the other hand, control passes to the block 308 if the SWITCH flag is set. Control returns to the block 304 following the block 308. As should be evident from the foregoing, if the switch 102 is closed when the LED 100 is off, the LED 100 is energized and remains in such state until the switch 102 is again closed or if the LED timer times out, whichever event first occurs. Such operation may be achieved in accordance with the table of FIG. 10, for example, as seen in connection with states tₛ₁₁ and tₛ₁₅.

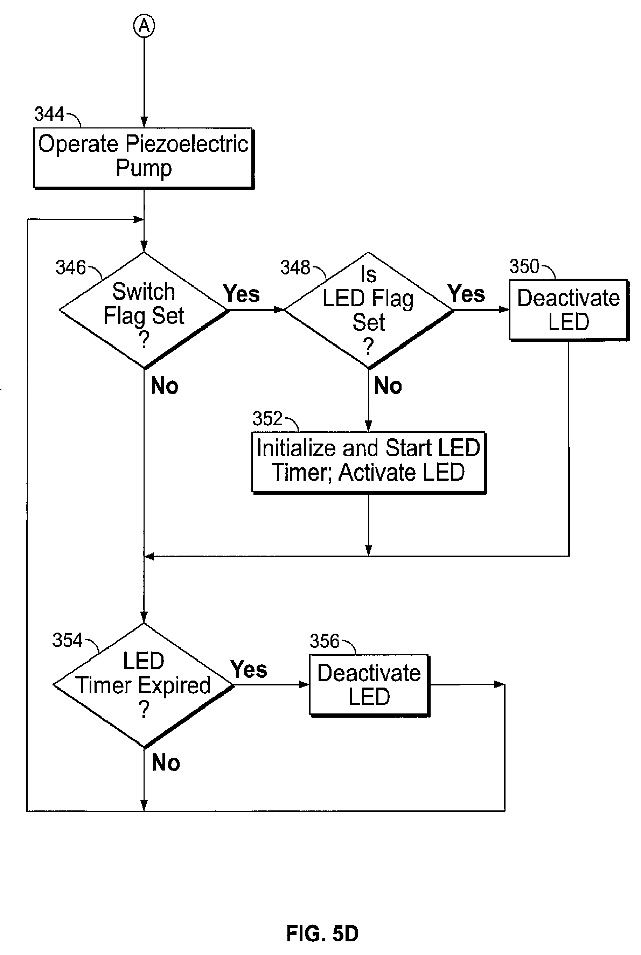

FIGS. 5C and 5D illustrate a third portion of programming that may be executed by the ASIC 150 to illuminate the LED 100 and operate the piezoelectric pump 166 to dispense the first volatile substance. This programming is executed in response to leaving the pin 2M unconnected to ground. States tₛ₁-tₛ₁₀ of FIG. 10 may be implemented by the programming of FIGS. 5C and 5D. Operation begins at a block 330 that checks the POWER ON RESET flag to determine whether such flag has been set. Once this occurs, control passes to a block 332 that initializes the internal registers of the ASIC 150 and activates the internal circuits such as the power on reset and undervoltage detector 154, the digital controller 156, the oscillator 152, the memory 158, and the charge pump and LED controller 160. Next, a block 334 checks the VDDHV flag to determine whether the VHHDV voltage at the pin 172 has reached the predetermined VDDHV voltage level. Once this is found to be the case, control passes to a block 336 that initializes and starts a START UP DELAY timer. Following the block 336, control passes to a block 338 that checks a START UP DELAY flag to determine whether such flag is set. The START UP DELAY flag is set when a START UP DELAY timer has expired. Control remains with the block 338 until the START UP DELAY flag is set. Next, control passes to a block 344 that operates the piezoelectric pump 166 in a normal (i.e., non-boost) mode. Control then passes to a block 346 that again checks the SWITCH flag to determine whether the user has closed the switch 102. If this is found to be the case, a block 348 determines whether an LED flag is set. The LED flag is set by the interrupt routine when the charge pump and LED controller 160 are active. If this is found to be true, control passes to a block 350 that turns off the LED 100. Otherwise, control passes to a block 352 that initializes and starts an LED timer and energizes the LED. Control then proceeds to a block 354 that checks an LED TIMER flag to determine whether the LED timer has expired. Control also passes directly to the block 354 from the block 350 and further passes from the block 346 to the block 354 if the SWITCH flag is not set.

If the block 354 determines that the LED timer has expired, a block 356 deactivates the LED 100. Control then returns to the block 346. Control also passes directly to the block 346 from the block 354 bypassing the block 356, if the LED timer has not expired.

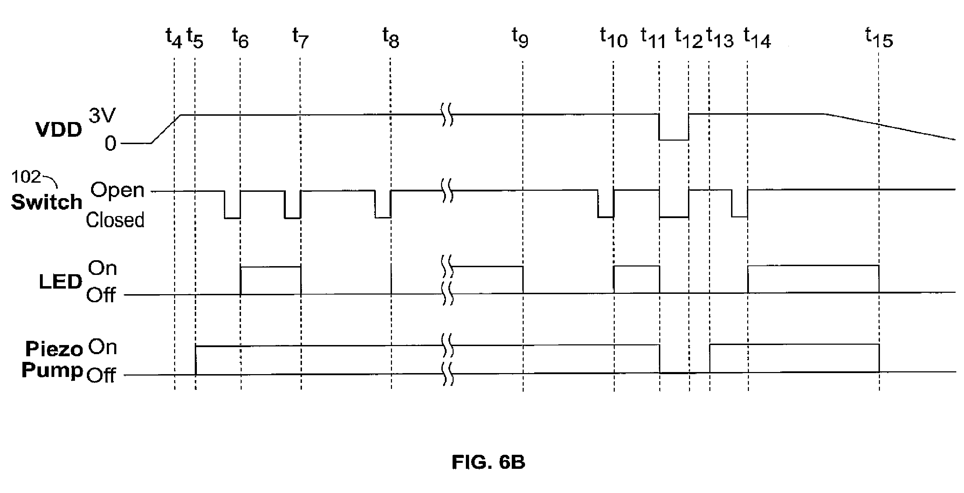

FIG. 6B illustrates the operation of the third portion of programming shown in FIGS. 5C and 5D wherein the device 30 operates as in the first mode to emit light and the first volatile substance. Graphs labeled "LED" and "Piezopump" reflect the operation of the LED 100 and the piezoelectric pump 166, respectively, in response to various conditions including the opening and closing of the switch 102 by the user. A waveform labeled "VDD" indicates the voltage level that the batteries 151A, 151B (FIG. 4) supply to the ASIC 150. The ASIC 150 senses a POWER ON RESET condition at a time t₄ and the ASIC 150 operates the piezoelectric pump 166 to dispense the first volatile substance at a time t₅ following the time at which VDD reaches the certain voltage level and following the start up delay period. Although not shown in FIG. 6B, the piezoelectric pump is operated by a waveform that includes a number of spray periods that have dwell periods interposed therebetween as shown in FIG. 6A.

The user closes the switch 102 for at least the debounce period and releases the switch 102 at a time t₆ to turn the LED 100 on. It is pertinent to note that the operation of the piezoelectric pump 166 is not affected when the user opens or closes the switch 102. Following the time t₆, the user closes the switch 102 for at least the debounce period at a time t₇ to turn the LED 100 off. The LED 100 is turned on again when the switch 102 is closed for at least the debounce period at a time t₈. Following the time t₈, if the switch 102 is not closed for at least the debounce period, the ASIC 150 turns the LED 100 off at a time t₉ as a result of operation of the block 356, FIG. 5D. As discussed with respect to FIG. 10, the LED timer period is variable and selected by the builder or implementer of the device 30. The switch 102 is closed for at least the debounce time at a time t₁₀ to turn the LED 100 on again.

Following the time t₁₀, an undervoltage condition occurs at a time t₁₁, as indicated by the drop in the VDD waveform (although shown as a sharp drop-off, in reality, the voltage VDD may drop gradually). Typically, an undervoltage condition occurs when the voltage source such as the batteries 151A, 151B (FIG. 4) is depleted or disconnected from the ASIC 150. The LED 100 and the piezoelectric pump 166 are turned off when the undervoltage condition occurs. When the user replaces the voltage source, for example at a later time t₁₂, the ASIC 150 activates the piezoelectric pump 166 after the appropriate delay period at a time t₁₃. Following the time t₁₃, the switch 102 is closed for at least the debounce period at a time t₁₄ to turn the LED 100 on. The LED 100 and the piezoelectric pump 166 remain on until another undervoltage condition occurs at a time t₁₅.

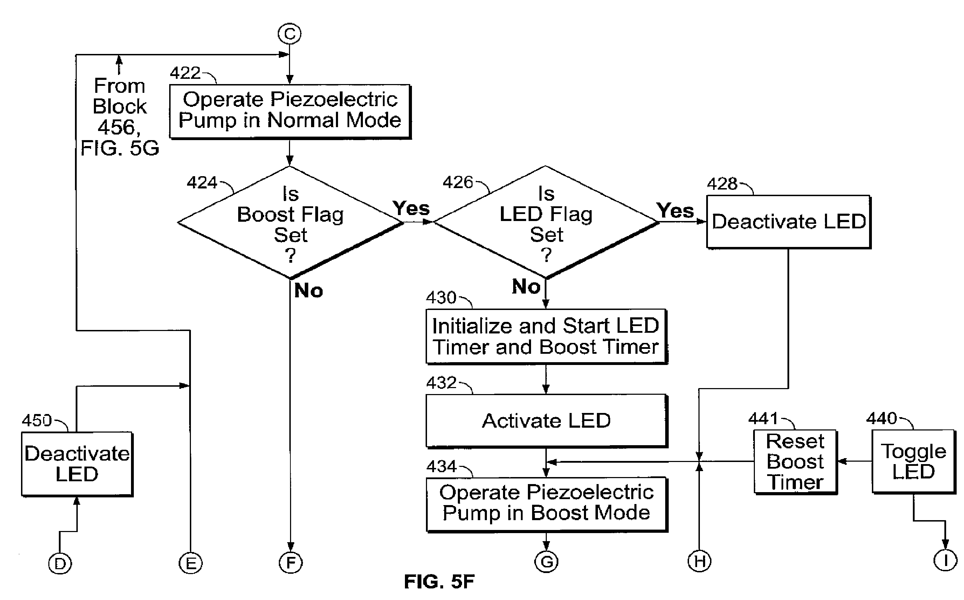

A fourth portion of programming that may be executed by the ASIC 150 is illustrated by FIGS. 5E-5G. The program portion is utilized with the circuitry of FIG. 4A to emit the first volatile substance in a selectively controllable fashion and to selectively energize the LED 100 using the boost switch 167. The states tₛ₁-tₛ₁₀, ts₁₂-tₛ₁₄ and tₛ₁₆ of FIG. 10 may be implemented by this program portion. Operation begins at a block 400 that checks the POWER ON RESET flag to determine whether a power-on-reset condition has occurred. Next, a block 402 initializes the internal registers of the ASIC 150 and activates the internal circuits such as power-on-reset and undervoltage detector 154, the digital controller 156, the oscillator 152, the memory 158, and the charge pump and LED controller 160. A block 404 then checks the VDDHV flag to determine whether the VDDHV voltage at the output pin 172 has reached a predetermined voltage level and control pauses at the block 404 until such level is reached. Once this condition occurs, control passes to a block 406 that initializes and starts a START UP DELAY timer. Following the block 406, control proceeds to a block 408 that checks the START UP DELAY flag to determine whether the START UP DELAY timer has expired. Control remains with the block 408 until the START UP DELAY flag is set. A block 422 (FIG. 5F) then operates the piezoelectric pump in the normal mode (i.e., the non-boost mode). Thereafter, a block 424 checks a BOOST flag to determine whether the boost switch 167 has been activated (i.e., depressed) by a user. If the BOOST flag is set, control passes to a block 426 that checks to determine whether the LED flag is set. If this is also found to be the case, a block 428 deactivates the LED 100 and control thereafter passes to a block 434 discussed hereinafter, Conversely, if the LED flag is not set, a block 430 initializes and starts a BOOST timer and the LED timer, a block 432 activates the LED 100, and the block 434 operates the piezoelectric pump 166 in a boost mode. As described in greater detail with respect to FIG. 11, the rate of volatile substance emission during the boost mode may be higher than the rate of volatile substance emission during the normal mode of operation.

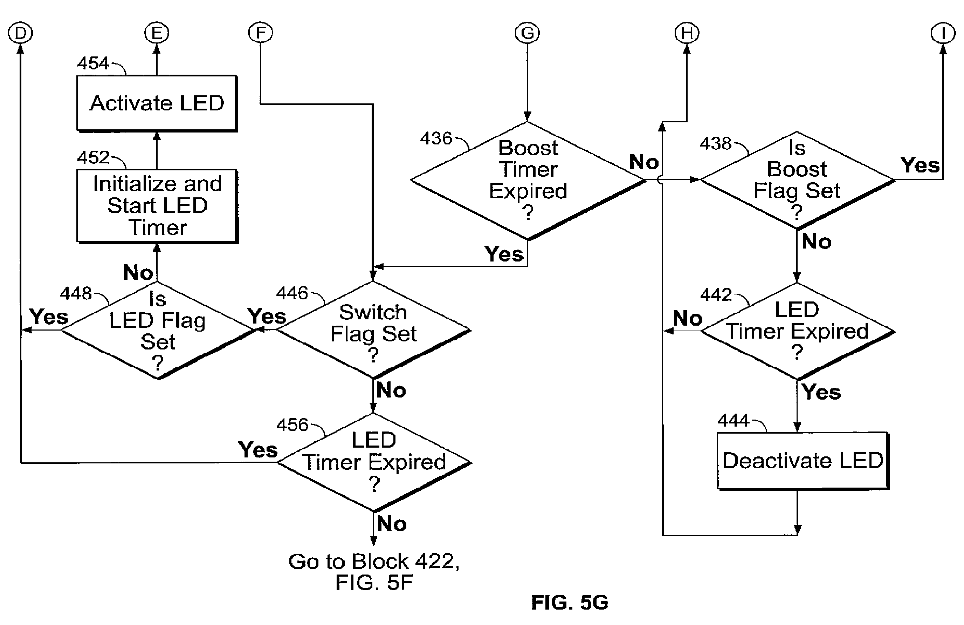

Following the block 434 a block 436 (FIG. 5G) checks a BOOST TIMER flag to determine whether the BOOST timer has expired. If this is not true, control passes to a block 438 that checks to determine whether the BOOST flag is set. If this is true, a block 440 (FIG. 5F) toggles the LED 100 (i.e., the LED 100 is turned on if it is currently off, and vice versa). A block 441 then optionally resets the BOOST timer and control 3 returns to the block 434. If the block 438 determines that the BOOST flag is not set, a block 442 determines whether the LED timer has expired. If this is the case a block 444 deactivates the LED 100 and control returns to the block 434 (FIG. 5G). The block 444 is bypassed if the block 442 determines that the LED timer has not expired.

If the block 424 (FIG. 5F) determines that the user has not closed the boost switch 167 or if the block 436 determines that the BOOST timer has expired, control passes to a block 446 that determines whether the SWITCH flag has been set. If this is true, a block 448 checks whether the LED flag is set to determine whether the LED is currently activated. If this is also the case, control passes to a block 450 that turns off the LED 100 and control returns to the block 422. Otherwise, control passes to a block 452 that initializes and starts the LED timer. Next, a block 454 turns on the LED 100. Following the block 454, the block 422 operates the piezoelectric pump 166 in the normal mode.

If the block 446 determines that the SWITCH flag has not been set, control passes to a block 456 that determines whether the LED timer has expired. If so the LED 100 is turned off by the block 450 and control returns to the block 422. Otherwise, the block 450 is bypassed and control returns directly to the block 422.

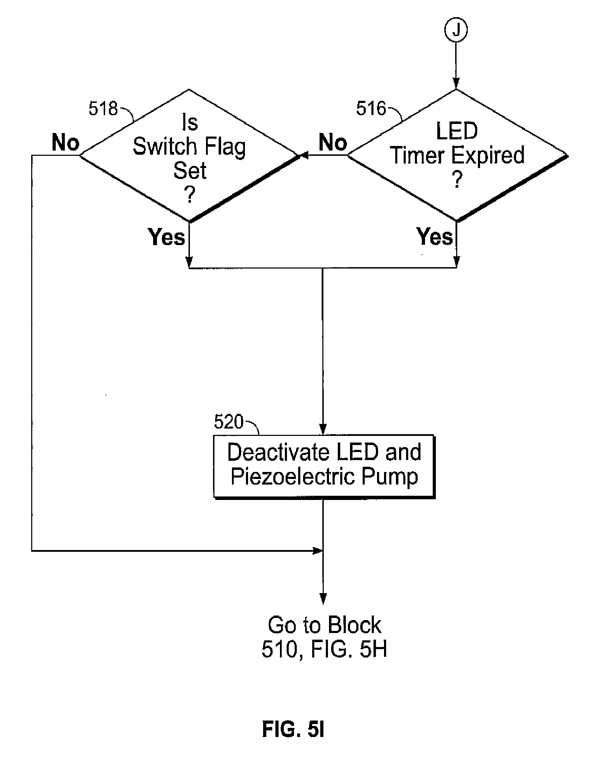

FIGS. 5H and 5I illustrate a fifth portion of programming that may be implemented by the ASIC 150 of FIG. 4. This programming is executed in connection with the circuitry of FIG. 4 when the pin 2M is connected to ground and the switch 167 is omitted to selectively dispense the second volatile substance and energize the LED 100. Control begins at a block 500 that checks the POWER ON RESET flag to determine whether the POWER ON RESET condition has arisen. Upon such occurrence, a block 502 initializes the internal registers of the ASIC 150. The block 502 also activates the internal circuits such as the POWER ON RESET and undervoltage detector 154, the digital controller 156, the oscillator 152, the memory 158, and the charge pump and LED controller 160. Control then passes to a block 504 that checks the VDDHV LEVEL flag to determine whether the voltage at the pin 172 has reached a predetermined voltage. Control remains with the block 504 until this condition has occurred. Next, control passes to a block 506 that initializes and starts the START UP DELAY timer. Following the block 506, a block 508 checks the START UP DELAY flag to determine whether the START UP DELAY timer has expired. Control remains with the block 508 until the START UP DELAY timer expires, whereupon control passes to a block 510 that checks the SWITCH flag to determine whether the user has closed the switch 102. Control remains with the block 510 until the SWITCH flag is closed by the user and control then passes to a block 512. The block 512 initializes and starts the LED timer if the LED 100 is to be operated in a timed mode as noted in greater detail thereafter. Next, control passes to a block 514 that activates the LED 100 and the piezoelectric pump according to FIG. 11.

Following the block 514, a block 516 (FIG. 5I) checks the LED TIMER flag to determine whether the LED timer has expired (again, this can only occur when the LED is being operated in the timed mode). If the LED timer has expired a block 520 deactivates the LED 100 and the piezoelectric pump 166 and control returns to the block 510 of FIG. 5H. Conversely, if the LED timer has not expired a block 518 determines whether the SWITCH flag has been set. If this is the case, then control passes to the block 520. Otherwise, control bypasses the block 520 and proceeds directly to the block 510 of FIG. 5H.

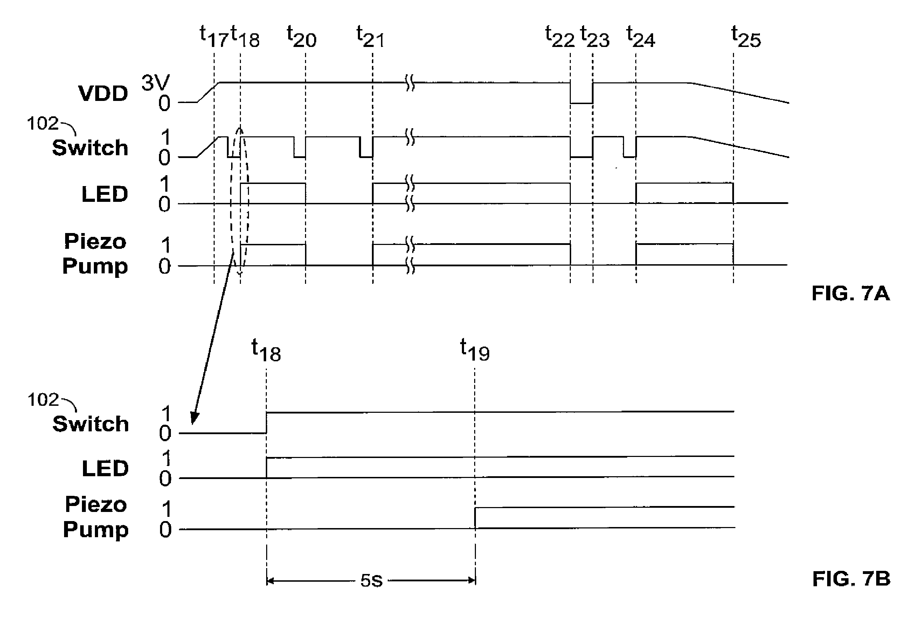

FIGS. 7A illustrates the operation of the programming portion of FIGS. 5H and 5I. In this case, the pin 2M is coupled to ground and the pin MODE is not connected to any voltage so as to implement the states tₛ₄₁₋ tₛ₄₈ of FIG. 11. Similar to the operation shown in FIG. 6B, the graphs labeled "LED" and "Piezopump" reflect the operation of the LED 100 and the piezoelectric pump 166, respectively. The LED 100 is turned on when the switch 102 is closed for at least the debounce period at a time t₁₈. However, the piezoelectric pump 166 does not begin operation until a predetermined second delay period expires at a time t₁₉ as shown in an exploded view of the period between the time t₁₈ and the time t₁₉ in FIG. 7B. Although not shown in FIG. 7A, the piezopump waveform includes a number of spray periods "s" having dwell periods "d" interposed therebetween, as illustrated in FIG. 6A. The switch 102 is closed for at least the debounce period at a time t₂₀ to turn the LED 100 and the piezoelectric pump 166 off. Following the time t₂₀, the switch 102 is again closed for at least the debounce period at a time t₂₁ to turn the LED 100 and the piezoelectric pump 166 on.

The LED 100 and the piezoelectric pump 166 remain on until an undervoltage condition occurs at a time t₂₂ which causes the ASIC 150 to turn off the LED 100 and the piezoelectric pump 166. The user replaces the voltage source at a time t₂₃ and the LED 100 and the piezoelectric pump 166 are turned on again when the switch 102 is closed for at least the debounce period at a time t₂₄. The LED 100 and the piezoelectric pump 166 remain on until another undervoltage condition occurs at a time t₂₅.

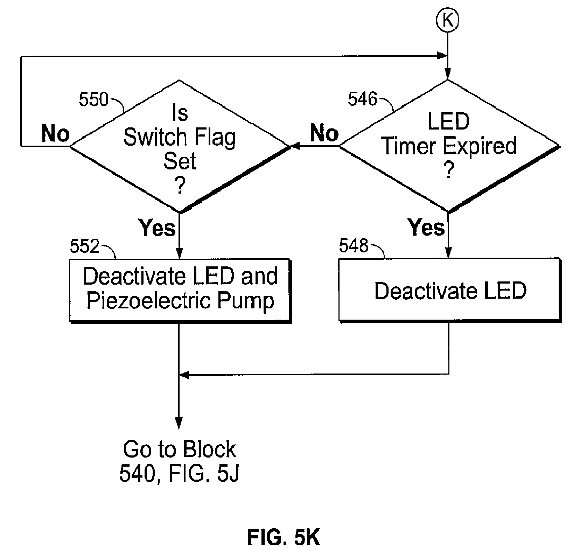

FIGS. 5J and 5K illustrate a sixth portion of programming usable with the circuitry of FIG. 4A when the switch 167 is used. Blocks 530-546 of FIGS. 5J and 5K are identical to blocks 500-516, respectively, of FIGS. 5H and 5I, and hence, this programming will not be described again. If the block 546 (FIG. 5L) determines that the LED timer has expired a block 548 deactivates the LED 100 alone. On the other hand, if the block 546 determines that the LED timer has not expired, a block 550 determines whether a user has closed the switch 102. If this is found to be the case, control passes to a block 552 that deactivates the LED 100 and the piezoelectric pump 160. Control from the blocks 548 and 552 returns to the block 540 of FIG. 5J. The sixth programming portion shown in FIGS. 5J and 5K may implement the states tₛ₄₉₋ tₛ₅₅ when both the 2M and MODE pins are connected to ground.

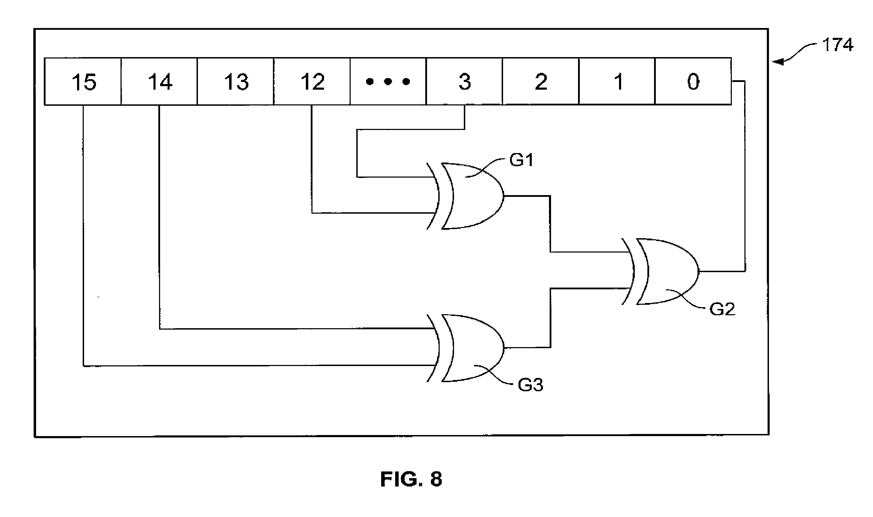

The LED 100 is operated in a pulse-width mode (PWM) of operation in the embodiments of the device 30 where the LED 100 is present. The duty cycle for the PWM waveform and the frequency for the PWM waveform are preferably (although not necessarily) fixed. The LED 100 is energized to obtain the flickering effect by utilizing a pseudo random number generator 174 (shown functionally in FIG. 8) in conjunction with a PWM value table forming a part of the LED controller 160 to establish a duty cycle for operation of the LED 100. The pseudo random number generator 174 is functionally shown in FIG. 8 as a series of three NOR gates G1, G2, and G3 coupled to particular bit positions of a sixteen-bit shift register SR. The least significant 8-bits of the pseudo random number generator are used to address the PWM value table. The initial value of the generator 174 is 3045 (hexadecimal). An 8-bit address register is used for selecting the PWM values in the PWM value table. More specifically, the six least significant bits of the 8-bit output of the address register are used to develop a six-bit table address pointer used to address the PWM table as described above. The 8-bit address register either counts up or down depending on the values of the most significant bit of the value that is generated by the pseudo random number generator 174.

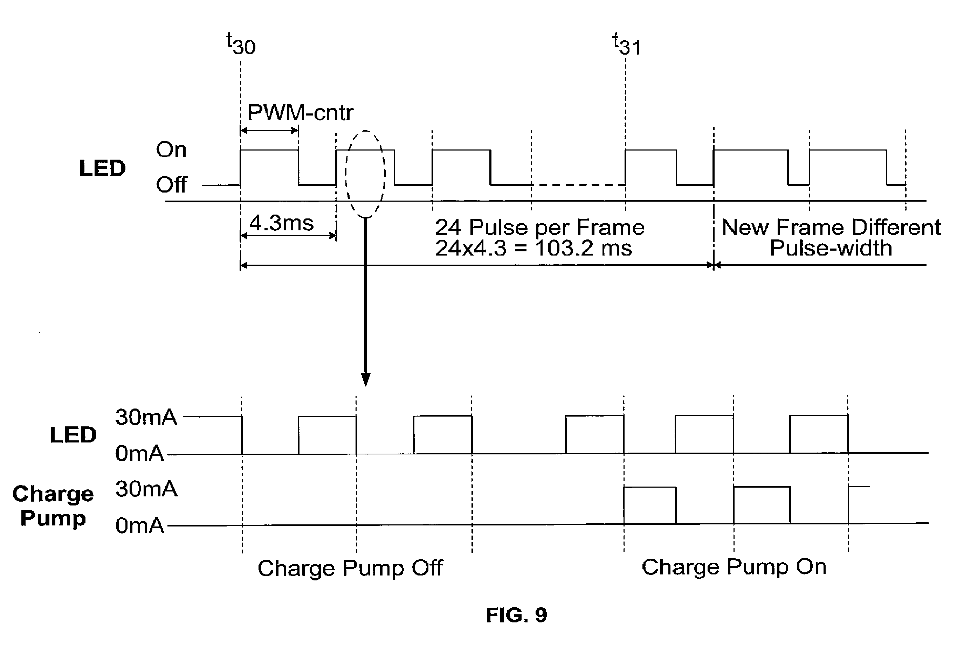

Turning to FIG. 9, the waveform labeled LED indicates the drive waveform applied to the LED 100 and the waveform labeled CHARGE PUMP reflects the drive waveform that is generated by the charge pump in the LED controller 160. A number of frames of equal duration are established wherein each frame includes a number of pulse cycles therein. Preferably, each pulse cycle is 4.3 milliseconds in length and 24 pulses are included per frame. Accordingly, each frame is 103.2 milliseconds in duration. Also preferably, the pulse on-times for a particular frame are all equal in duration, resulting in a particular average current magnitude for that frame. In general, the LED 100 is operated intermittently at a high frequency so as to provide the appearance that the LED 100 is being operated at a constant intensity level over a period of time. In one embodiment, the LED 100 has a 30 milliamp peak current and a typical pulse-width of about 8.4 microseconds. If desired, these values may be changed to obtain different LED intensities. The pulse-widths in adjacent frames are different so as to provide an average current different from the particular average current magnitude to provide the flickering effect. The choice of the pulse-widths for the frames is controlled by the pseudo random generator 174 and entries in PWM value table. When the combined voltage developed by the batteries drops below the voltage required to adequately energize the LED 100, the charge pump 160 is actuated (as shown at a time t31) to provide sufficient forward voltage to the LED 100. Specifically, the LED 100 receives the current pulses as described previously and the charge pump 160 is turned on to charge the capacitor C_{LED} of FIGS. 4 and 4A. The capacitor C_{LED} thereafter provides sufficient voltage to the LED 100 to maintain adequate drive thereto.

As shown in FIGS. 10 and 11 and as noted above, the ASIC 150 may be programmed to emit a volatile substance at various intervals depending on the commanded mode of operation. In addition, when the LED 100 is activated, the LED 100 may be programmed to turn off at the expiration of a specified time period. For example, when the user moves the actuator arm to the position P5 in the state tₛ₁ shown in FIG. 10, the device 30 emits a pulse of the first volatile substance during an approximate 12ms spray period once every 6 seconds and the ASIC 150 causes the LED 100 to turn off automatically after 3 hours. The rate of emission of the first volatile substance in the normal mode of operation can be varied as shown by states tₛ₂-tₛ₁₀ in FIG. 10. It should be noted that the MODE input pin is left open when operation in the states tₛ₁-tₛ₅ is commanded and the MODE input pin is connected to ground in the states tₛ₆-tₛ₁₀. FIG. 10 further illustrates sub-states tₛ₁₁-tₛ₁₆ that can be activated during any of the aforementioned states when the boost switch 167 is incorporated into the device 30 and closed to connect two of the switches SW1, SW2, SW4, and SW5 to ground. In the states tₛ₁₁ and tₛ₁₅, the ASIC 150 causes the LED 100 to emit light continuously for a period of 3 and 2 hours, respectively. The ASIC 150 turns the LED 100 off after the 3 or 2 hour period and the ASIC 150 continues normal operation in any of the states tₛ₁-tₛ₅ or tₛ₆-tₛ₁₀ that was in effect before the user closed the boost switch 167. Similarly, the operation of the ASIC 150 in states tₛ₁-tₛ₅ or tₛ₆-tₛ₁₀ is interrupted when the user closes the boost switch 167 and the device 30 emits a pulse of the first volatile substance once every 0.25 seconds for periods of 12, 4, 7, and 10 seconds in states tₛ₁₂, tₛ₁₃, tₛ₁₄, and tₛ₁₆, respectively, and the LED is activated for a period of 2 hours. The LED turns off after the 2 hour period and the ASIC 150 reverts to operation in any of the states tₛ₁-tₛ₅ or tₛ₆-tₛ₁₀ that may have been in effect before the user closed the boost switch 167.

As seen in FIG. 11, the device 30 can be commanded to emit the second volatile substance at different duty-cycles and illuminate the LED 100 for varying time periods. For example, the device 30 emits a pulse of the second volatile substance once every 0.264 seconds and causes the LED 100 to turn off after 5 hours of continuous illumination in a state tₛ₄₁. It is contemplated that the emission duty-cycle of the second volatile substance can be varied as depicted by states tₛ₄₂-tₛ₄₅. The builder or implementer of device 30 can also program the device 30 to operate in any of states tₛ₄₆-tₛ₄₈, tₛ₄₉-tₛ₅₂, and states tₛ₅₃-tₛ₅₆. In the state tₛ₄₆, the device 30 emits a pulse of the second volatile substance once every 0.388 seconds and the LED 100 remains on until an undervoltage condition occurs or the device 30 is turned off. States tₛ₄₇ and tₛ₄₈ are similar to state tₛ₄₆ except that the device emits the second volatile substance once every 0.326 and 0.264 seconds, respectively. It should be noted that the MODE input pin is left open (i.e., unconnected to any external circuitry) when operation in the states tₛ₄₁-tₛ₄₈ is commanded. In the state tₛ₄₉, the device 30 emits a pulse of the second volatile substance once every 5.412 seconds and the LED 100 remains on until an undervoltage condition occurs or the device 30 is turned off. Similarly, the device 30 emits a pulse of the second volatile substance once every 6, 7.18, and 7.862 seconds in states tₛ₅₀-tₛ₅₂, respectively. When the state tₛ₅₃ is activated, the device 30 emits a pulse of the second volatile substance once every 5.412 seconds and the LED 100 is turned off after 2 hours of continuous illumination. The states tₛ₅₄, tₛ₅₅, and tₛ₅₆ are similar to the state tₛ₅₃ except that the device 30 emits a pulse of the second volatile substance once every 6, 7.18, and 7.862 seconds in the states tₛ₅₄, tₛ₅₅ and tₛ₅₆, respectively. Further, the LED 100 turns off after 2 hours of continuous illuminations in states tₛ₅₄, tₛ₅₅ and tₛ₅₆. The 2 hour continuous illumination period is accomplished in the states tₛ₅₃, tₛ₅₄, tₛ₅₅ and tₛ₅₆ due to the connection of SW1 to ground as shown in FIG. 11.

Any of the above-described circuits may be incorporated in any device having a piezoelectric element and/or one or more lighting light emitting diode(s), including but not limited to any of the devices disclosed in U.S. Patent Nos. 6,450,419, 7,017,829, 7,469,844, Helf et. al. U.S. Patent Publication No. 2007/0235555, filed April 11, 2006, Schramm U.S. Patent Publication No. 2007/0012718, filed June 29, 2006, Mungavalasa et. al. U.S. Patent Publication No. 2008/0011874, filed July 14, 2006, or Helf et. al. U.S. Patent Publication No. 2008/0036332, filed December 8, 2006.

Numerous modifications to the device 30 will be apparent to those skilled in the art in view of the foregoing description. Accordingly, this description is to be construed as illustrative only.

## Claims

1. A circuit for a volatile material emitting device, comprising:
a piezoelectric pump (58, 166) including an impedance (168) connected in series with a piezoelectric element (62), wherein the impedance and the piezoelectric element (62) form a tank circuit (168, 62) having a resonant frequency;
a driver (164) connected to the piezoelectric pump, wherein the driver comprises four transistors (180, 182, 184, 186) coupled in a full bridge configuration, having first and second p-channels transistors (180, 184) with their respective source electrodes coupled to a high voltage supply and first and second n-channel transistors (182, 186) with their respective source electrodes coupled to ground, the drain electrode of the first p-channel transistor (180) being connected to the drain electrode of the first n-channel transistor (182) to form a first output pin (OUT1) and the drain electrode of the second p-channel transistor (184) being connected to the drain electrode of the second n-channel transistor (186) to form a second output pin (OUT2), wherein the tank circuit (168, 62) is connected between the first output pin (OUT1) and the second output pin (OUT2);
wherein the driver (164) is adapted to generate a drive waveform to drive the transistors (180, 182, 184, 186) in one of a first and second states comprising a first state in which the first p-channel transistor (180) and the second n-channel transistor (186) are turned "ON" and the second p-channel transistor (184) and the first n-channel transistor (182) are turned "OFF", and
a second state in which the first p-channel transistor (180) and the second n-channel transistor (186) are turned "OFF" and the second p-channel transistor (184) and the first n-channel transistor (182) are turned "ON";
**characterized in that** the circuit further comprises:
first and second comparators (192, 194) coupled between the driver (164) and the tank circuit (168, 62), wherein the comparators (192, 194) are adapted to detect a parameter of power applied to the piezoelectric pump (58, 166) by the driver (164) to operate the piezoelectric pump (58, 166) at a mechanical resonant frequency thereof;
said first comparator (192) having its inputs connected between the first output pin (OUT1) and ground;
said second comparator (194) having its inputs connected between the second output pin (OUT2) and ground;
the driver being configured to switch to the first state when the first comparator (192) detects a zero crossing of voltage across its inputs representing a zero crossing of current in the first n-channel transistor (182), and to switch to the second state when the second comparator (194) detects a zero crossing of voltage across its inputs representing a zero crossing of current in the second n-channel transistor (186).

2. The circuit according to claim 1 wherein the driver is adapted to interpose a period of time when switching between said first and second states to prevent a short circuit condition.

3. The circuit according to claim 1 or 2, including a switch (109) for selecting a rate at which power is applied to the piezoelectric pump (58).

4. The circuit according to any of the preceding claims, wherein the piezoelectric pump is adapted to operate in a plurality of operating modes.

5. The circuit of claim 4, wherein the piezoelectric pump is adapted to dispense a volatile fragrance in an operating mode.

6. The circuit of claim 4, wherein the piezoelectric pump is adapted to dispense either an insecticide or an insect replant in an operating mode.

## Patentansprüche

1. Schaltung für eine Vorrichtung zur Ausgabe eines flüchtigen Stoffs, die aufweist:
eine piezoelektrische Pumpe (58, 166) mit einer Impedanz (168), die in Reihe mit einem piezoelektrischen Element (62) liegt, wobei die Impedanz und das piezoelektrische Element (62) einen Schwingkreis (168, 62) mit einer Resonanzfrequenz bilden;
eine Treiberstufe (164), die mit der piezoelektrischen Pumpe verbunden ist und vier Transistoren (180, 182, 184, 186) aufweist, die zu einer Vollbrücke verschaltet sind und einen ersten und einen zweiten p-Kanal-Transistor (180, 184), deren Source-Elektroden an einer Hochspannung liegen, und einen ersten und einen zweiten n-Kanal-Transistor (182, 186) aufweisen, deren Source-Elektroden an Masse liegen, wobei die Drain-Elektrode des ersten p-Kanal-Transistors (180) mit der Drain-Elektrode des ersten n-Kanal-Transistors (182) verbunden ist, um einen ersten Ausgangsanschluss (OUT1) zu bilden, und die Drain-Elektrode des zweiten p-Kanal-Transistors (184) mit der Drain-Elektrode des zweiten n-Kanal-Transistors (186) verbunden ist, um einen zweiten Ausgangsanschluss (OUT2) zu bilden, und wobei der Schwingkreis (168, 62) zwischen dem ersten Ausgangsanschluss (OUT1) und dem zweiten Ausgangsanschluss (OUT2) liegt;
wobei mit der Treiberstufe (164) ein ansteuernder Wellenzug erzeugbar ist, mit dem die Transistoren (180, 182, 184, 186) in einen von zwei Zuständen schaltbar sind, von denen in einem ersten Zustand der erste p-Kanal-Transistor (180) und der zweite n-Kanal-Transistor (186) EIN- und der zweite p-Kanal-Transistor (184) und der erste n-Kanal-Transistor (182) AUSgeschaltet sind; und
in einem zweiten Zustand der erste p-Kanal-Transistor (180) und der zweite n-Kanal-Transistor (186) AUS- und der zweite p-Kanal-Transistor (184) und der erste n-Kanal-Transistor (182) EINgeschaltet sind;
**dadurch gekennzeichnet, dass** die Schaltung weiterhin
einen ersten und einen zweiten Komparator (192, 194) aufweist, die zwischen der Treiberstufe (164) und dem Schwingkreis (168, 62) liegen und mit denen ein Parameter des elektrischen Signals detektierbar ist, das die Treiberstufe (164) an die piezoelektrische Pumpe (58, 166) legt, um diese mit einer mechanischen Resonanzfrequenz derselben zu betreiben; wobei
der erste Komparator (192) mit seinen Eingängen zwischen den ersten Ausgangsanschluss (OUT1) und Masse und der zweite Komparator (194) mit seinen Eingängen zwischen den zweiten Ausgangsanschluss (OUT2) und Masse gelegt ist; und
die Treiberstufe ausgeführt ist, in den ersten Zustand zu schalten, wenn der erste Komparator (192) einen Nulldurchgang der Spannung über seinen Eingängen erfasst, der einen Nulldurchgang des Stroms im ersten n-Kanal-Transistor (182) darstellt, und in den zweiten Zustand zu schalten, wenn der zweite Komparator (194) einen Nulldurchgang der Spannung über seinen Eingängen erfasst, der einen Nulldurchgang des Stroms im zweiten n-Kanal-Transisor (86) darstellt.

2. Schaltung nach Anspruch 1, bei der die Treiberstufe beim Umschalten zwischen dem ersten und dem zweiten Zustand ein Zeitintervall einfügen kann, um einen Kurzschlusszustand zu verhindern.

3. Schaltung nach Anspruch 1 oder 2 mit einem Schalter (109) zur Auswahl der Schnelligkeit, mit der die piezoelektrische Pumpe (58) angesteuert wird.

4. Schaltung nach einem der vorgehenden Ansprüche, bei der die piezoelektrische Pumpe in mehreren betrieblichen Zuständen betreibbar ist.

5. Schaltung nach Anspruch 4, bei der die piezoelektrische Pumpe in einem der Betriebszustände einen flüchtigen Duftstoff ausgeben kann.

6. Schaltung nach Anspruch 4, bei der die piezoelektrische Pumpe in einem der Betriebszustände entweder einen Duftstoff oder ein Insektenabwehrmittel ausgeben kann.

## Revendications

1. Circuit pour un dispositif d'émission de matière volatile, comprenant :
une pompe piézoélectrique (58, 166) incluant une impédance (168) raccordée en série avec un élément piézoélectrique (62), dans lequel l'impédance et l'élément piézoélectrique (62) forment un circuit oscillant final (168, 62) ayant une fréquence de résonance ;
une commande (164) reliée à la pompe piézoélectrique, dans lequel la commande comprend quatre transistors (180, 182, 184, 186) couplés dans une configuration de pont complet, ayant des premier et second transistors à canal p (180, 184) avec leurs électrodes de source respectives couplées à une alimentation à tension élevée et des premier et second transistors à canal n (182, 186) avec leurs électrodes de source respectives couplées à la masse, l'électrode de drain du premier transistor à canal p (180) étant reliée à l'électrode de drain du premier transistor à canal n (182) pour former une première broche de sortie (OUT1) et l'électrode de drain du second transistor à canal p (184) étant reliée à l'électrode de drain du second transistor à canal n (186) pour former une seconde broche de sortie (OUT2), dans lequel le circuit oscillant final (168, 62) est raccordé entre la première broche de sortie (OUT1) et la seconde broche de sortie (OUT2) ;
dans lequel la commande (164) est adaptée pour générer une forme d'onde de commande pour commander les transistors (180, 182, 184, 186) dans l'un des premier et second états comprenant un premier état dans lequel le premier transistor à canal p (180) et le second transistor à canal n (186) sont passés "à l'état passant" et le second transistor à canal p (184) et le premier transistor à canal n (182) sont passés "à l'état bloqué", et
un second état dans lequel le premier transistor à canal p (180) et le second transistor à canal n (186) sont passés "à l'état bloqué" et le second transistor à canal p (184) et le premier transistor à canal n (182) sont passés "à l'état passant" ;
**caractérisé en ce que** le circuit comprend en outre :
des premier et second comparateurs (192, 194) couplés entre la commande (164) et le circuit oscillant final (168, 62), dans lequel les comparateurs (192, 194) sont adaptés pour détecter un paramètre d'alimentation appliquée à la pompe piézoélectrique (58, 166) par la commande (164) pour faire fonctionner la pompe piézoélectrique (58, 166) à une fréquence de résonance mécanique de celle-ci ;
ledit premier comparateur (192) ayant ses entrées raccordées entre la première broche de sortie (OUT1) et la masse ;
ledit second comparateur (194) ayant ses entrées raccordées entre la seconde broche de sortie (OUT2) et la masse ;
la commande étant configurée pour basculer vers le premier état lorsque le premier comparateur (192) détecte un passage par zéro de la tension entre ses entrées représentant un passage par zéro du courant dans le premier transistor à canal n (182), et pour basculer vers le second état lorsque le second comparateur (194) détecte un passage par zéro de la tension entre ses entrées représentant un passage par zéro du courant dans le second transistor à canal n (186).

2. Circuit selon la revendication 1, dans lequel la commande est adaptée pour interposer une période de temps lors de la commutation entre lesdits premier et second états pour empêcher un état de court-circuit.

3. Circuit selon la revendication 1 ou 2, incluant un commutateur (109) pour sélectionner une vitesse à laquelle de l'énergie est appliquée à la pompe piézoélectrique (58).

4. Circuit selon l'une quelconque des revendications précédentes, dans lequel la pompe piézoélectrique est adaptée pour fonctionner dans une pluralité de modes de fonctionnement.

5. Circuit selon la revendication 4, dans lequel la pompe piézoélectrique est adaptée pour distribuer une fragrance volatile dans un mode de fonctionnement.

6. Circuit selon la revendication 4, dans lequel la pompe piézoélectrique est adaptée pour distribuer soit un insecticide soit un insectifuge dans un mode de fonctionnement.
